# EUROPÄISCHE PATENTANMELDUNG

(11) **EP 2 876 513 A1**
(43) Veröffentlichungstag der Anmeldung: **27.05.2015**
(21) Anmeldenummer: 13194414.2
(22) Anmeldetag: 26.11.2013
(51) Int. Cl.: G05B 17/02, G05B 19/418, G06F 17/50

(54) **Verfahren zum Testen des Einflusses einer Änderung an einer Rezeptprozedur**

(71) Anmelder: Siemens Aktiengesellschaft, 80333 München (DE)
(72) Erfinder: Hartich, Marco, 76726 Germersheim (DE); Horst, Andre, 76187 Karlsruhe (DE); Roßkopf, Harald, 76327 Pfinztal-Wöschbach (DE)

(57) **Zusammenfassung**

Die Erfindung betrifft ein Verfahren zum Testen des Einflusses einer Änderung an einer auf einer grafischen Benutzeroberfläche eines Batch-Clients darstellbaren Rezeptprozedur (8), welche zur Steuerung eines Batchprozesses mittels eines Batch-Servers (6) vorgesehen ist, wobei die Rezeptprozedur (8) eine Vielzahl von Rezeptelementen (R1 bis R4) umfasst und wobei während des Steuerbetriebs der Batch-Server (6) die Rezeptprozedur (8) abarbeitet und korrespondierend dazu ein mit dem Batch-Server online verbundenes Automatisierungsgerät (10) zu den Rezeptelementen (R1 bis R4) zugeordnete Softwarebausteine eines Steuerprogramms verarbeitet. Es werden Maßnahmen vorgeschlagen, mittels welcher eine vereinfachte Simulation der Rezeptprozedur (8) ermöglicht wird.

## Beschreibung

Die Erfindung betrifft ein Verfahren zum Testen des Einflusses einer Änderung an einer auf einer grafischen Benutzeroberfläche eines Batch-Clients darstellbaren Rezeptprozedur, welche zur Steuerung eines Batchprozesses mittels eines Batch-Servers vorgesehen ist, wobei die Rezeptprozedur eine Vielzahl von Rezeptelementen umfasst und wobei während des Steuerbetriebs der Batch-Server die Rezeptprozedur abarbeitet und korrespondierend dazu ein mit dem Batch-Server online verbundenes Automatisierungsgerät zu den Rezeptelementen zugeordnete Softwarebausteine eines Steuerprogramms verarbeitet. Darüber hinaus betrifft die Erfindung eine zur Durchführung des Verfahrens geeignete Anordnung mit einem Automatisierungsgerät, mit einem Batch-Client und mit einem Batch-Server.

Geeignete Hard- und Software-Komponenten eines Batch-Systems zur Verwirklichung eines derartigen Verfahrens sind aus dem Siemens-Katalog "Prozessleitsystem SIMATIC PCS 7 - Systemkomponenten, Ausgabe Juni 2013", Kapitel 13, bekannt. Mittels einer so genannten auf einem Batch-Client ablauffähigen "BATCH Software" erstellt ein Anwender eine Rezeptprozedur zur Steuerung eines Batch- bzw. -Chargenprozesses, beispielsweise eine Rezeptprozedur zur Herstellung von Kunstharz, Farbstoffen oder Düngemitteln. Eine derartige Rezeptprozedur weist gewöhnlich eine Vielzahl von parallelverzweigten Teilrezepturen auf, die jeweils mehrere Rezeptelemente in Form von Rezeptoperationen oder Rezeptfunktionen, z. B. Dosieren, Heizen oder Rühren, sowie Transitionen umfassen. Die Rezeptoperationen und/oder die Rezeptfunktionen stehen während des Steuerbetriebs in Wirkverbindung mit geeigneten Hard- und Softwarekomponenten einer Automatisierungseinrichtung, die gewöhnlich mindestens ein mit Funktionsbaugruppen versehenes Automatisierungsgerät umfasst, welches über einen Bus mit einer Vielzahl von Feldgeräten verbunden ist. Während dieses Steuerbetriebs arbeitet ein Batch-Server des Batch-Systems die Rezeptprozedur ab und korrespondierend dazu verarbeitet das mit dem Batch-Server online verbundene Automatisierungsgerät zu jeder Rezeptoperation bzw. Rezeptfunktion jeweils einen dieser Operation oder Funktion zugeordneten Softwarebaustein. Diese Softwarebausteine wurden vor dem Steuerbetrieb beispielsweise mittels eines Engineering-Systems in das Automatisierungsgerät geladen. Selbstverständlich werden weitere Software-Bausteine in das Automatisierungsgerät geladen, um Ergänzungen an der Rezeptprozedur mittels weiterer Rezeptelemente vornehmen zu können; denn zu den weiteren Rezeptelementen sind korrespondierende Software-Bausteine auf dem Automatisierungsgerät erforderlich, die während der Abarbeitung der Rezeptelemente - also während der Steuerung des Batchprozesses - mittels dieser Rezeptelemente angesprochen werden, wobei die Rezeptelemente den Software-Bausteinen gewöhnlich Sollwerte und die Software-Bausteine den Rezeptelementen Istwerte übermitteln.

Aufgrund dessen, dass der online mit dem Automatisierungsgerät verbundene Batch-Server nicht zu Testzwecken zur Verfügung steht, ist zum Testen einer Rezeptprozedur gewöhnlich ein Simulations-Server vorgesehen. Dieser Server ist derart ausgebildet, dass nur die komplette Rezeptprozedur getestet werden kann. Dies ist insbesondere dann störend, wenn nur geringfügige Änderungen an der Rezeptprozedur vorgenommen werden müssen, z. B. in der Art und Weise, dass diese Rezeptprozedur nur um wenige Rezeptelemente zu ergänzen ist bzw. ergänzt werden soll. Trotz dieser geringfügigen Änderung muss die komplette Rezeptprozedur auf dem Simulations-Server getestet werden, was sehr zeitintensiv ist, zumal es sich häufig um langläufige Batchprozesse bzw. Rezeptprozeduren handelt.

Der Erfindung liegt daher die Aufgabe zugrunde, ein Verfahren der eingangs genannten Art anzugeben, mittels welchem der Einfluss von Änderungen an einer Rezeptprozedur vereinfacht getestet werden kann. Darüber hinaus ist eine Anordnung zu schaffen, welche zur Durchführung des Verfahrens geeignet ist.

Diese Aufgabe wird im Hinblick auf das Verfahren durch die im kennzeichnenden Teil des Anspruchs 1, bezüglich der Anordnung durch die im kennzeichnenden Teil des Anspruchs 4 angegebenen Maßnahmen gelöst.

Vorteilhaft ist, dass eine Rezeptprozedur mit neuen Rezeptelementen getestet werden kann, ohne dass die Rezeptprozedur auf dem Batch-Server beeinflusst wird. Diese neuen Rezeptelemente werden nicht der Rezeptprozedur des laufenden Batch- bzw. Chargenprozesses, sondern in Form von neuen Simulations-Rezeptelementen dem Simulations-Server - der Bestandteil des Batch-Servers sein kann - zugeführt, wobei während des Tests der laufende Batch- bzw. Chargenprozess nicht angehalten werden muss.

In einer Ausgestaltung der Erfindung ist vorgesehen, Verbindungen zwischen dem Batch-Server und dem Automatisierungsgerät sowie zwischen dem Batch-Server und den Simulations-Automatisierungsfunktionen mittels Proxy zu verwirklichen. Mittels einer derartigen Kommunikationsschnittstelle wird ein "fließender" Übergang von der Simulation in die Produktion ermöglicht.

Anhand der Zeichnung, in der ein Ausführungsbeispiel der Erfindung veranschaulicht ist, werden im Folgenden die Erfindung, deren Ausgestaltungen sowie Vorteile näher erläutert.

Es zeigen
- Figur 1: eine Anordnung mit einem Batch- und einem Simulations-Server und
- Figur 2: eine Rezeptprozedur.

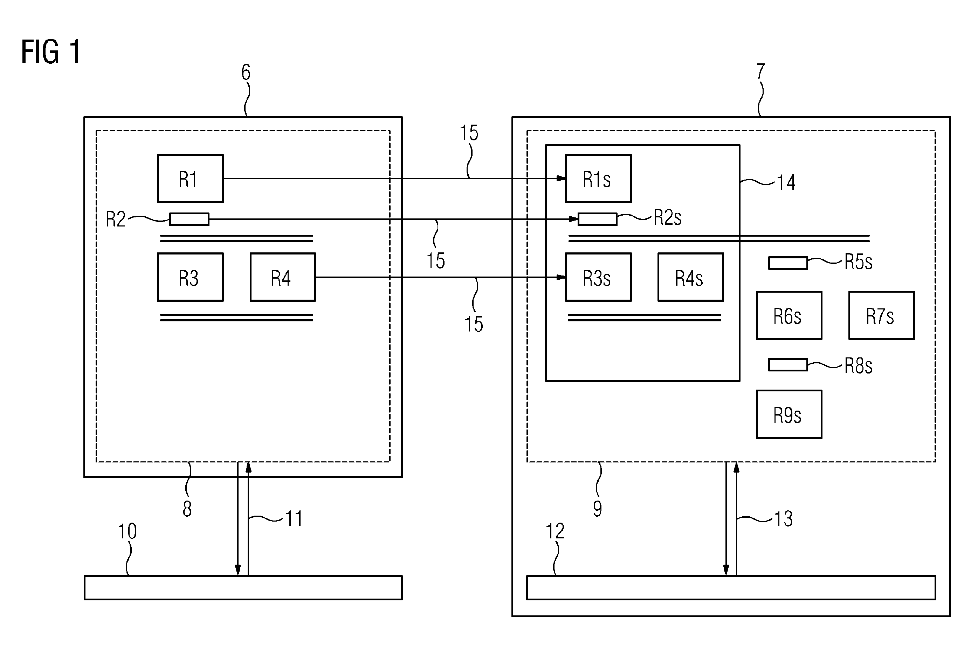

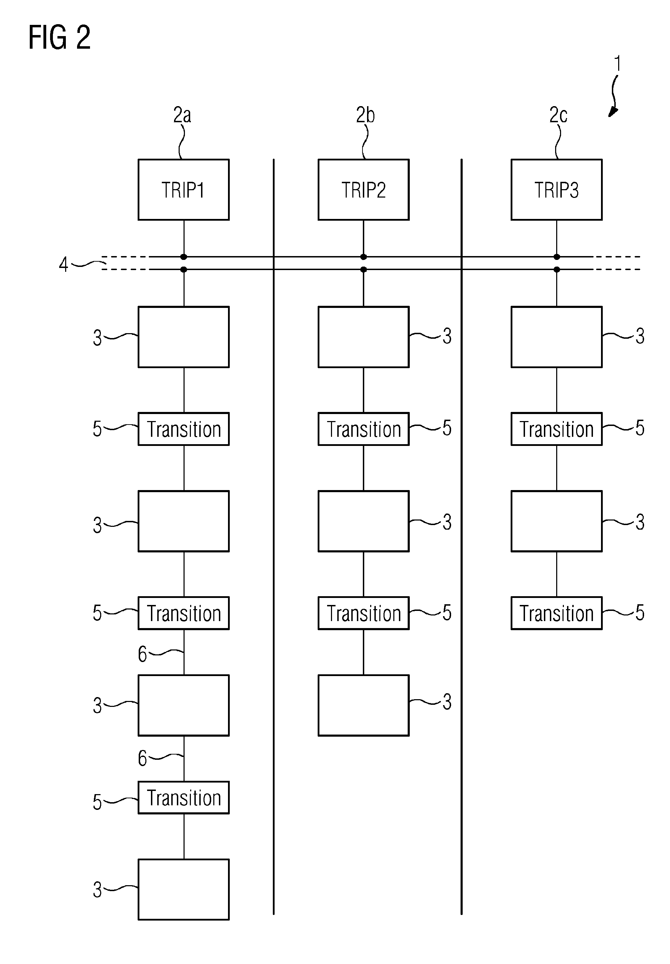

Die in den Figuren 1 und 2 dargestellten gleichen Teile sind mit gleichen Bezugszeichen versehen.

Es wird zunächst auf Figur 2 verwiesen, in welcher eine Rezeptprozedur 1 eines Batch- bzw. Chargenprozesses gezeigt ist, die in einer an sich bekannten Art und Weise auf einer Anzeigeeinheit eines Batch-Clients eines Batch-Systems dargestellt ist. Diese Rezeptprozedur 1, welche ein Anwender mittels einer Batch-Software bzw. mittels eines Rezepteditors des mit einer geeigneten Benutzeroberfläche versehenen Batch-Clients erstellt, ist zur Steuerung eines technischen Prozesses vorgesehen, beispielsweise eines Prozesses zur Herstellung von Kunstharz. Die Rezeptprozedur 1 weist mehrere Teilrezeptprozeduren 2a, 2b, 2c auf, die jeweils einen Teilprozess bzw. eine Prozessstufe auf einer Teilanlage steuern. Jede dieser über eine Parallelverzweigung 4 verbundene Teilrezeptprozeduren 2a, 2b, 2c ist versehen mit einer Vielzahl von vertikal verbundenen Rezeptelementen, z. B. Rezeptoperationen (ROP) 3, oder Transitionen 5, wobei jede dieser Rezeptoperationen 3, z. B. eine Rezeptoperation "Heizen", "Dosieren" oder "Mischen", wiederum eine Vielzahl von Rezeptelementen aufweisen kann. Selbstverständlich kann die Rezeptprozedur 1 weitere Parallelverzweigungen und/oder weitere Teile umfassen, z. B. Synchronisationslinien, Schleifen, Operatoranweisungen oder Alternativabzweigungen.

Die Rezeptprozedur 1 steht während des Steuerbetriebs in Wirkverbindung mit geeigneten Hard- und Softwarekomponenten eines Automatisierungsgerätes. Dabei arbeitet während dieses Steuerbetriebs der Batch-Server sequentiell die Rezeptprozedur 1 ab, wobei korrespondierend dazu das mit dem Batch-Server online verbundene Automatisierungsgerät zu jedem Rezeptelement jeweils einen diesem Rezeptelement zugeordneten Softwarebaustein bzw. Software-Funktionsbaustein abarbeitet.

Um den Einfluss einer Änderung an der Rezeptprozedur zu testen, ist ein mit dem Batch-Server kommunikativ verbundener Simulations-Server zur Verarbeitung eines Simulations-Batchprozesses vorgesehen, wobei dieser Simulations-Server Bestandteil des Batch-Servers sein kann.

Zur näheren Erläuterung wird dazu auf Figur 1 verwiesen, in welcher in einer vereinfachten grafischen Darstellung eine Anordnung mit einem Batch-Server 6 und einem Simulations-Server 7 gezeigt ist. Zum besseren Verständnis der Erfindung und der Einfachheit halber sind auf den Servern 6, 7 Teile von ablauffähigen Rezeptprozeduren in Form von grafischen Rezeptprozeduren 8, 9 gezeigt, wie sie auf einem Batch-Client darstellbar sind und von einem Anwender mittels dieses Batch-Clients erstellt werden. Ferner sind zur besseren Übersicht keine Verbindungslinien zwischen den Rezeptelementen in der Rezeptprozedur 8 sowie in der Simulations-Rezeptprozedur 9 dargestellt. Selbstverständlich sind in diesen Servern 6, 7 die Rezeptprozeduren 8, 9 in einer mittels dieser Server 6, 7 lesbaren und verarbeitbaren Form hinterlegt.

Während der Verarbeitung der Rezeptprozedur 8, d. h. während der Steuerung des Batch- bzw. Chargenprozesses, erzeugt der Batch-Server 6 eine Kopie der Rezeptprozedur 8 und übermittelt diese Kopie dem Simulations-Server 7, welcher diese Kopie als Simulations-Rezeptprozedur 9 in einem Speicher des Simulations-Servers 7 hinterlegt und verarbeitet. Im Rahmen dieser Verarbeitung stehen die Rezeptelemente der Simulations-Rezeptprozedur 9 mit auf dem Simulations-Server 7 hinterlegten Simulations-Automatisierungsfunktionen eines zu simulierenden Automatisierungsgerätes in Wirkverbindung. Zur Verdeutlichung ist dazu in der Zeichnung mit 10 ein Automatisierungsgerät angedeutet, welches über eine geeignete Busverbindung Informationen 11 mit dem Batch-Server 6 austauscht. Ferner sind mit dem Bezugszeichen 12 Simulations-Automatisierungsfunktionen des (realen) Automatisierungsgerätes 10 bezeichnet, wobei die Simulations-Automatisierungsfunktionen 12 softwaretechnisch die Funktions- und Wirkungsweise von Hard-und/oder Software-Bausteinen des (realen) Automatisierungsgerätes 10 nachbilden und wobei die Simulations-Automatisierungsfunktionen 12 mit den Rezeptelementen der Simulations-Rezeptprozedur 9 in Wirkverbindung stehen. Dazu werden zwischen der Simulations-Rezeptprozedur 9 und den Simulations-Automatisierungsfunktionen 12 Informationen 13 ausgetauscht. In diesem Zusammenhang wird unter der Formulierung "in Wirkverbindung stehen" verstanden, dass einerseits zwischen der Simulations-Rezeptprozedur 9 und den Simulations-Automatisierungsfunktionen 12 Informationen 13 ausgetauscht werden, und anderseits, dass zur Steuerung eines Simulations-Batchprozesses der Simulations-Server 7 die Simulations-Rezeptprozedur 9 sequentiell abarbeitet und korrespondierend dazu die den Simulations-Rezeptelementen zugeordneten Softwarebausteine eines Simulations-Steuerprogramms der Simulations-Automatisierungsfunktionen 12 verarbeitet.

Die Simulations-Rezeptelemente der Simulations-Rezeptprozedur 9, die den Rezeptelementen der Rezeptprozedur 8 des Batch-Servers 6 entsprechen und welche der Batch-Server 6 dem Simulations-Server 7 übermittelte, markiert der Simulations-Server 7 automatisch als nicht veränderbar. In der Zeichnung sind Simulations-Rezeptelemente R1s, R2s, R3s, R4s der Simulations-Rezeptprozedur 9 auf dem Simulations-Server 7, welche der Anwender nicht verändern kann und welche Rezeptelementen R1, R2, R3, R4 der Rezeptprozedur 8 des Batch-Servers 6 entsprechen, mittels einer Umrandung 14 gekennzeichnet. Die jeweiligen Simulations-Rezeptelemente R1s, R2s, R3s, R4s werden über Status- und/oder Werte und/oder Parameterwechsel der jeweiligen Rezeptelemente R1, R2, R3, R4 benachrichtigt und mit diesen Werten versorgt, nachdem der Simulations-Server 7 die Simulations-Rezeptelemente R1s, R2s, R3s, R4s beim Batch-Server 6 angemeldet hat, wobei nach jeder Benachrichtigung die jeweiligen Simulations-Rezeptelemente R1s, R2s, R3s, R4s auf den Status und/oder den Wert und/oder den Parameterwert der jeweiligen Rezeptelemente R1, R2, R3, R4 lesend zugreifen und übernehmen, was in der Zeichnung mittels Pfeilen 15 angedeutet ist. Ein Zugriff dieser Simulations-Rezeptelemente R1s, R2s, R3s, R4s auf die Hard- und/oder Software-Bausteine des (realen) Automatisierungsgerätes 10 wird durch den Batch-Server 6 oder durch den Simulations-Server 7 blockiert.

Mittels eines hier nicht dargestellten Simulations-Clients oder mittels des mit dem Batch-Server 6 und mit dem Simulations-Server 7 verbundenen Batch-Clients erstellt der Anwender z. B. weitere Simulations-Rezeptelemente, wobei den Simulations-Rezeptelementen entsprechende Rezeptelemente für die Rezeptprozedur 8 vorgesehen sind. Die Simulations-Rezeptelemente werden zunächst mittels des Simulations-Servers 7 im Rahmen der Verarbeitung der Simulations-Rezeptprozedur 9 getestet, um den Einfluss der diese Simulations-Rezeptelementen repräsentierenden Rezeptelemente auf den realen Prozess bzw. auf die Rezeptprozedur 8 zunächst zu prüfen. Im vorliegenden Ausführungsbeispiel sind die weiteren und neu erstellten Rezeptelemente der Simulations-Rezeptprozedur 9 mit R5s, R6s, R7s, R8s, R9s bezeichnet, die wiederum der Einfachheit halber grafisch dargestellt sind.

Aufgrund dessen, dass der Simulations-Server 7 nun die um die weiteren Simulations-Rezeptelemente R5s bis R9s erweiterte Simulations-Rezeptprozedur 9 verarbeitet, wobei die Simulations-Rezeptprozedur 9 während der Steuerung des Batch-Prozesses weiterhin mittels des Batch-Servers 6 mit Status- und/oder Parameterwechsel im Hinblick auf die Rezeptelemente R1 bis R4 der Rezeptprozedur 8 versorgt wird, und wobei die Simulations-Rezeptelemente R5s bis R9s in Wirkverbindung mit den Simulations-Automatisierungsfunktionen 12 stehen, erkennt der Anwender den Einfluss der vorgenommen Änderung bzw. Ergänzung an der Simulations-Rezeptprozedur 9.

Für den Fall, dass aufgrund dieser Änderung bzw. Ergänzung der gewünschte Verlauf des Simulations-Batchprozesses bewerkstelligt wird, kann der Anwender die mit den neuen Simulations-Rezeptelementen R5s bis R9s versehene Simulation-Rezeptprozedur 9 als zukünftige Rezeptprozedur (Grundrezept) für einen Chargenprozess vorsehen.
Wie beschrieben, werden die neuen Rezeptelemente nicht der Rezeptprozedur des laufenden Batch- bzw. Chargenprozesses, sondern in Form von neuen Simulations-Rezeptelementen dem Simulations-Server zugeführt und zusammen mit den ursprünglichen Simulations-Rezeptelementen, welche den ursprünglichen Rezeptelementen der Batch-Rezeptprozedur entsprechen, getestet. Der Test wird bewerkstelligt, ohne dass die Rezeptprozedur auf dem Batch-Server beeinflusst wird, wobei während des Tests der laufende Batch- bzw. Chargenprozess nicht angehalten werden muss.

## Patentansprüche

1. Verfahren zum Testen des Einflusses einer Änderung an einer auf einer grafischen Benutzeroberfläche eines Batch-Clients darstellbaren Rezeptprozedur (8), welche zur Steuerung eines Batchprozesses mittels eines Batch-Servers (6) vorgesehen ist, wobei die Rezeptprozedur (8) eine Vielzahl von Rezeptelementen (R1 bis R4) umfasst und wobei während des Steuerbetriebs der Batch-Server (6) die Rezeptprozedur (8) abarbeitet und korrespondierend dazu ein mit dem Batch-Server online verbundenes Automatisierungsgerät (10) zu den Rezeptelementen (R1 bis R4) zugeordnete Softwarebausteine eines Steuerprogramms verarbeitet, **dadurch gekennzeichnet, dass** während des Batchprozesses mittels eines Simulations-Servers (7) , welcher mit Simulations-Automatisierungsfunktionen (12) des Automatisierungsgerätes (10) versehen ist, der Einfluss der Änderung an der Rezeptprozedur (8) getestet wird, indem
- eine Kopie der Rezeptprozedur (8) erzeugt und auf dem Simulations-Server als Simulations-Rezeptprozedur (9) mit Simulations-Rezeptelementen (R1s bis R4s) hinterlegt wird,
- die Simulations-Rezeptelemente (R1s bis R4s) automatisch als nicht veränderbar markiert werden,
- die Simulations-Rezeptelemente (R1s bis R4s) mit Status- und/oder Parameterwechseln der den Simulations-Rezeptelementen (R1s bis R4s) entsprechenden Rezeptelemente (R1 bis R4) der Rezeptprozedur (8) versorgt werden,
- der Simulations-Rezeptprozedur (9) neue Simulations-Rezeptelemente (R5s bis R9s) hinzugefügt werden, welche die Änderungen repräsentieren, wobei die mit den neuen Simulations-Rezeptelementen (R5s bis R9s) versehene Simulations-Rezeptprozedur (9) mit den Simulations-Automatisierungsfunktionen (12) in Wirkverbindung steht.

2. Verfahren nach Anspruch 1, **dadurch gekennzeichnet, dass** der Simulations-Server (7) als Bestandteil des Batch-Servers (6) ausgebildet wird.

3. Verfahren nach Anspruch 2, **dadurch gekennzeichnet, dass** Verbindungen zwischen dem Batch-Server (6) und dem Automatisierungsgerät (10) sowie zwischen dem Batch-Server (6) und den Simulations-Automatisierungsfunktionen (12) mittels Proxy verwirklicht werden.

4. Anordnung mit einem Automatisierungsgerät, mit einem Batch-Client und mit einem Batch-Server, wobei zur Steuerung eines Batchprozesses mittels des Batch-Servers (6) eine auf einer grafischen Benutzeroberfläche des Batch-Clients darstellbare Rezeptprozedur (8) vorgesehen ist, die eine Vielzahl von Rezeptelementen (R1 bis R4) umfasst, wobei ferner während des Steuerbetriebs der Batch-Server (6) die Rezeptprozedur (8) abarbeitet und korrespondierend dazu ein mit dem Batch-Server (6) online verbundenes Automatisierungsgerät (10) zu den Rezeptelementen (R1 bis R4) zugeordnete Softwarebausteine eines Steuerprogramms verarbeitet, **dadurch gekennzeichnet, dass** ein Simulations-Server (7) mit simulierten Automatisierungsfunktionen (12) des Automatisierungsgerätes (10) vorgesehen ist, wobei zum Testen des Einflusses einer Änderung an der Rezeptprozedur (8) während des Batchprozesses,
- der Batch-Server (7) dazu ausgebildet ist, eine Kopie der Rezeptprozedur (8) zu erzeugen und als Simulations-Rezeptprozedur (9) mit Simulations-Rezeptelementen (R1s bis R4s) dem Simulations-Server (7) zu übermitteln,
- der Simulations-Server (7) dazu ausgebildet ist, die Simulations-Rezeptelemente (R1s bis R4s) automatisch als nicht veränderbar zu markieren und zu hinterlegen,
- der Batch-Server (6) dazu ausgebildet ist, die Simulations-Rezeptelemente (R1s bis R4s) mit Status- und/oder Parameterwechseln der den Simulations-Rezeptelementen (R1s bis R4s) entsprechenden Rezeptelemente der Rezeptprozedur (R1 bis R4) zu versorgen,
- der Simulations-Server (7) dazu ausgebildet ist, der Simulations-Rezeptprozedur (9) neue Simulations-Rezeptelemente (R5s bis R9s) hinzuzufügen, welche die Änderungen repräsentieren, wobei die mit den neuen Simulations-Rezeptelementen (R5s bis R9s) versehene Simulations-Rezeptprozedur (9) mit den simulierten Automatisierungsfunktionen (12) in Wirkverbindung steht.

5. Anordnung nach Anspruch 4, **dadurch gekennzeichnet, dass** der Simulations-Server (7) Bestandteil des Batch-Servers (6) ist.

6. Anordnung nach Anspruch 5, **dadurch gekennzeichnet, dass** Verbindungen zwischen dem Batch-Server (6) und dem Automatisierungsgerät (10) sowie zwischen dem Batch-Server (6) und den Simulations-Automatisierungsfunktionen (12) mittels Proxy verwirklicht sind.
